Europäisches Patentamt

European Patent Office

Office européen des brevets

(19)

(11) **EP 1 133 826 B1**

(12) **EUROPÄISCHE PATENTSCHRIFT**

(45) Veröffentlichungstag und Bekanntmachung des Hinweises auf die Patenterteilung:
**14.08.2002 Patentblatt 2002/33**

(21) Anmeldenummer: **99964364.6**

(22) Anmeldetag: **23.11.1999**

(51) Int Cl.$^7$: **H03J 7/04**

(86) Internationale Anmeldenummer:
**PCT/DE99/03715**

(87) Internationale Veröffentlichungsnummer:
**WO 00/31868 (02.06.2000 Gazette 2000/22)**

(54) **FREQUENZSTABILISIERTE SENDE-/EMPFANGSANORDNUNG**

FREQUENCY-STABILISED TRANSMITTING/RECEIVING ARRANGEMENT

DISPOSITIF EMETTEUR/RECEPTEUR STABILISE EN FREQUENCE

(84) Benannte Vertragsstaaten:
**AT BE CH CY DE DK ES FI FR GB GR IE IT LI LU MC NL PT SE**

(30) Priorität: **24.11.1998 DE 19854167**

(43) Veröffentlichungstag der Anmeldung:
**19.09.2001 Patentblatt 2001/38**

(73) Patentinhaber: **Infineon Technologies AG**
**81669 München (DE)**

(72) Erfinder:
- **DOETSCH, Markus**
  **D-81539 München (DE)**
- **JUNG, Peter**
  **D-67697 Otterberg (DE)**
- **PLECHINGER, Jörg**
  **D-80469 München (DE)**
- **SCHMIDT, Peter**
  **D-67167 Erpolzheim (DE)**

(74) Vertreter: **Lange, Thomas, Dr.**
**Patentanwälte**
**Lambsdorff & Lange**
**Dingolfinger Strasse 6**
**81673 München (DE)**

(56) Entgegenhaltungen:
**US-A- 5 241 688**

- **CHARBIT G ET AL: "Frame synchronisation and frequency-carrier estimation for GSM mobile communications" EPMCC '97. SECOND EUROPEAN PERSONAL MOBILE COMMUNICATIONS CONFERENCE ZUSAMMEN MIT 3. ITG-FACHTAGUNG, MOBILE KOMMUNIKATION, BONN, DEUTSCHLAND, 30 SEPT.-2 OKT. 1997, Bd. 145, Nr. 145, 30. September 1997 (1997-09-30), Seiten 449-457-457, XP002100275 BONN, DEUTSCHLAND**

**Beschreibung**

Die Erfindung betrifft frequenzstabilisierte Schaltungsanordnungen, insbesondere Sende-/Empfangsanordnung nach den Oberbegriffen der Ansprüche 1 und 6. Derartige Schaltungsanordnungen kommen in Kommunikationsendgeräten (Basisstation und Mobilstation) von Mobil-Kommunikationssystemen zum Einsatz.

In der Praxis steht für die Übertragung von Nachrichten zumeist nur ein eng begrenzter Bandbreitenbereich zur Verfügung. Um eine möglichst große Nachrichtenmenge übertragen zu können, gilt es, den verfügbaren Bandbreitenbereich so effizient wie nur möglich auszunutzen. Zum einen ermöglichen Vielfachzugriffsverfahren wie Zeitmultiplex (TDMA, time division multiple access), Frequenzmultiplex (FDMA, frequency division multiple access), Codemultiplex (CDMA, code division multiple access) und Raummultiplex (SDMA, space division multiple access) sowie Kombinationen der genannten Vielfachzugriffsverfahren eine flexible und bedarfsorientierte Ausnutzung der verfügbaren Bandbreite. Andererseits muß auch auf der Hardwareseite für eine bestmögliche Ausnutzung des verfügbaren Bandbreitenbereichs gesorgt werden.

In der Mobilfunktechnik ist die verfügbare Gesamtbandbreite in Verkehrskanäle mit vorgegebener Kanalbandbreite aufgeteilt, wobei einem Teilnehmer bei Einwahl in das Mobilfunknetz ein bestimmter Verkehrskanal zugewiesen wird. Das Hochfrequenzteil des mobilen Kommunikationsendgerätes (im folgenden als Mobilstation bezeichnet) wird mittels der Empfangsmischstufe auf die zugewiesene Kanal(mitten)frequenz abgestimmt, und außerhalb des Kanalbandbreitenbereichs liegende Signalanteile werden im Zwischenfrequenz- (ZF-) oder Basisbandbereich durch geeignete Filter (Bandpaßfilter oder Tiefpaßfilter) aus dem empfangenen Signal entfernt.

Bei der Filterung besteht die Gefahr, daß in unbeabsichtigter Weise informationstragende Frequenzbereiche des empfangenen Signals weggefiltert werden. Dem liegen die folgenden Ursachen zugrunde:

Bei einer Bewegung der Mobilstation relativ zu der stationären Basisstation tritt aufgrund des Doppler-Effekts eine Frequenzverschiebung zwischen dem von der Mobilstation empfangenen HF-Empfangssignal und dem von der Basisstation auf der vorgegebenen Kanalfrequenz gesendeten Funksignal auf. Diese Doppler-Frequenzverschiebung wird durch das Heruntermischen in das analoge ZF-Empfangssignal und das digitale Empfangssignal übertragen und bewirkt eine Fehlanpassung derselben in Hinblick auf den .spektralen Durchlaßbereich des nachgeschalteten Filters.

Ferner tragen langsame Drifts und schnelle zeitliche Fluktuationen der in der Empfangsmischstufe zum Heruntermischen des HF-Empfangssignals eingesetzten Mischfrequenz zu unerwünschten Signalverlusten bei. Derartige Drifts und Fluktuationen der Mischfrequenz werden durch Temperaturdrifts bzw. Phasenrauschen des verwendeten Oszillators hervorgerufen.

Es ist im Stand der Technik bereits bekannt, in dem von der Basisstation ausgesendeten Funksignal in regelmäßigen Zeitabständen sogenannte Frequenzkorrekturblöcke (FCB, frequency correction burst) zu senden. Der FCB wird in dem Hochfrequenzteil der Mobilstation mit einem Frequenzraster der Rasterweite von beispielsweise 20 kHz gesucht. Durch Abstimmung auf die Rasterfrequenz mit der maximalen FCB-Empfangssignalstärke kann der FCB mit der Genauigkeit der Rasterweite ermittelt werden. Die Mischfrequenz wird dann in Abhängigkeit von der ermittelten Rasterfrequenz nachgeregelt. Auf diese Weise können relativ langsame, durch den Doppler-Effekt und Drifts der Mischfrequenz bewirkte Frequenzverschiebungen ausgeglichen werden.

Zur Reduzierung der schnellen Frequenzfluktuationen ist es bereits bekannt, Oszillatoren mit geringem Phasenrauschen einzusetzen. Nachteilig ist jedoch, daß rauscharme Oszillatoren verhältnismäßig teuer sind.

In U.S. 5,241,688 ist eine Schaltung zur Frequenzsynchronisation eines Mobilfunkempfängers beschrieben. Bei Detektion eines FCB wird mittels eines I/Q-Decoders im digitalen Signalverarbeitungsabschnitt des Mobilfunkempfängers ein Steuersignal erzeugt, das einem lokalen Oszillator zugeführt wird und eine Kompensation des Frequenzversatzes bewirkt. Zur Erzeugung dieses Steuersignals wird im I/Q-Decoder eine Schätzung der Signalenergie hinter einer adaptiven Bandpaßfilterung eingesetzt.

Der Erfindung liegt die Aufgabe zugrunde, eine für den Einsatz in einem Kommunikationsendgerät geeignete Schaltungsanordnung zu schaffen, die kostengünstig realisierbar ist und eine gute spektrale Ausnutzung eines Verkehrskanals vorgegebener Bandbreite ermöglicht.

Nach einem ersten Aspekt der Erfindung wird die Aufgabe durch die Merkmale des Anspruchs 1 gelöst.

Gemäß Anspruch 1 wird das zur Nachstellung der Mischfrequenz benötigte erste Frequenzkorrektur-Steuersignal nicht wie zumeist im Stand der Technik in dem Hochfrequenzteil generiert, sondern in dem Frequenzschätzer auf rechnerischem Wege ermittelt.

Der Frequenzschätzer ist in einem Kanalschätzer implementiert. Die Erfindung setzt somit lediglich eine entsprechende Programmierung des (bei Mobilfunkanwendungen ohnehin erforderlichen) Kanalschätzers voraus und ist somit kostengünstig und in Hardware-effizienter Weise in der Schaltungsanordnung implementierbar.

Die Empfangsmischstufe kann in einen Frequenzbereich reduzierter Frequenz oder auch direkt in das Basisband (sog. "direct downconversion") heruntermischen. Der in Anspruch 1 verwendete Begriff ZF-Frequenz soll jede bezüglich der Trägerfrequenz reduzierte Frequenz einschließlich des Basisbands bezeichnen.

Vorzugsweise ist die Schaltungsanordnung nicht nur als Empfänger sondern auch als Sender ausgelegt. Die Signalverarbeitungsschaltung weist dann ferner einen digitalen Modulator und einen DA-Umsetzer auf, und das Hochfrequenzteil ist mit einer Sendemischstufe ausgestattet. Ein von dem digitalen Modulator erzeugtes und von dem DA-Umsetzer ausgegebenes analoges Sendesignal wird dem Hochfrequenzteil zugeführt und in der Sendemischstufe durch Heraufmischen mit einer gemäß dem ersten Frequenzkorrektur-Steuersignal eingestellten weiteren Mischfrequenz in ein HF-Sendesignal umgesetzt. Die in bezug auf das Empfangsteil der erfindungsgemäßen Schaltungsanordnung angegebenen Vorteile gelten für das Sendeteil in gleicher Weise.

Eine bevorzugte Ausgestaltung der Erfindung kennzeichnet sich durch einen Oszillator mit steuerbarer Oszillatorfrequenz, dem das erste Frequenzkorrektur-Steuersignal zugeführt wird, wobei die Mischfrequenz und/oder die weitere Mischfrequenz von der Oszillatorfrequenz abgeleitet wird.

Für die Ermittlung des Frequenzversatzes enthält ein von einer Basisstation gesendetes Funksignal vorzugsweise einen zeitlich wiederkehrenden Frequenzkorrekturblock-Signalanteil (FCB) in Form einer Sinusschwingung, und der Frequenzschätzer schätzt den Frequenzversatz aus einer Auswertung eines Signalanteils des gefilterten digitalen Empfangssignals, dem der Frequenzkorrekturblock-Signalanteil (FCB) des Funksignals zugrundeliegt.

Vorzugsweise wird der Frequenzkorrekturblock-Signalanteil (FCB) alle 10 bis 100 ms von der Basisstation gesendet. Das erste Frequenzkorrektur-Steuersignal kann dann mit der gleichen Rate, d.h. ebenfalls alle 10 bis 100 ms, ermittelt werden. Diese Rate ist ausreichend, um langsame Frequenzverschiebungen, wie sie beispielsweise durch eine Drift des Oszillatorquarzes infolge von Temperaturänderungen bewirkt werden, auszuregeln.

Gemäß einem zweiten Aspekt der Erfindung wird die vorstehend angegebene Aufgabe durch die Merkmale des Anspruchs 6 gelöst.

Ähnlich wie bei der Lösung nach Anspruch 1 wird auch hier in dem Frequenzschätzer auf rechnerischem Wege ein (zweites) Frequenzkorrektur-Steuersignal ermittelt, das für den Frequenzversatz zwischen dem analogen ZF-Empfangssignal und einer für einen Durchlaßbereich des digitalen Filters charakteristischen Frequenz repräsentativ ist. Anders als bei der Lösung gemäß Anspruch 1 wird das zweite Frequenzkorrektur-Steuersignal jedoch nicht zur Nachstellung der Mischfrequenz sondern entweder zu einer spektralen Nachbearbeitung des digitalen Empfangssignals vor dem digitalen Filter oder zu einer Nachstellung des Durchlaßbereichs des digitalen Filters verwendet.

Auch bei dieser Lösung werden die erfindungsgemäßen Maßnahmen auf rechnerischem Wege ausgeführt, ohne einen Zusatzaufwand im Bereich der Hardware erforderlich zu machen.

Bei der Lösung nach Anspruch 6 ist die Schaltungsanordnung vorzugsweise ebenfalls mit weiteren Schaltungseinrichtungen zum Senden eines Funksignals ausgestattet. In diesem Fall umfaßt die Signalverarbeitungsschaltung ferner einen digitalen Modulator und einen DA-Umsetzer, wobei ein von dem digitalen Modulator bereitgestelltes moduliertes digitales Sendesignal von dem DA-Umsetzer in ein analoges Sendesignal umgesetzt wird. Das zweite Frequenzkorrektur-Steuersignal wird dem digitalen Modulator zugeführt, wobei der digitale Modulator die Frequenz des modulierten digitalen Sendesignals in Abhängigkeit von dem zweiten Frequenzkorrektur-Steuersignal verändert.

Nach einer bevorzugten Ausführungsform der Erfindung verwendet der Frequenzschätzer zur Schätzung des Frequenzversatzes das Verfahren der Momentberechnung. Es hat gezeigt, daß dieses Verfahren eine besonders genaue und aufwandsgünstige Ermittlung des Frequenzversatzes ermöglicht.

Es kann vorgesehen sein, daß der Frequenzschätzer für jedes Datensymbolen des gefilterten digitalen Empfangssignals jeweils eine Neuermittlung des zweiten Frequenzkorrektur-Steuersignals durchführt. Durch diese symbolweise Ermittlung des zweiten Frequenzkorrektur-Steuersignals wird eine größtmögliche Zeitauflösung erreicht. Durch eine hohe Zeitauflösung wird eine wirksame Ausregelung der schnellen Frequenzfluktuationen ermöglicht, die durch Phasenrauschen des Oszillators verursacht werden.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnung erläutert; in dieser zeigt:

Fig. 1    eine schematische Darstellung einer erfindungsgemäßen Schaltungsanordnung in Form eines Blockschaltbildes;

Fig. 2    eine schematische Darstellung der Frequenzspektren eines HF-Empfangssignals und eines aus diesem durch Heruntermischen erzeugten ZF-Empfangssignals;

Fig. 3    eine schematische Darstellung der Struktur eines Mehrfachrahmens; und

Fig. 4    eine schematische Darstellung der Struktur eines Datenblocks.

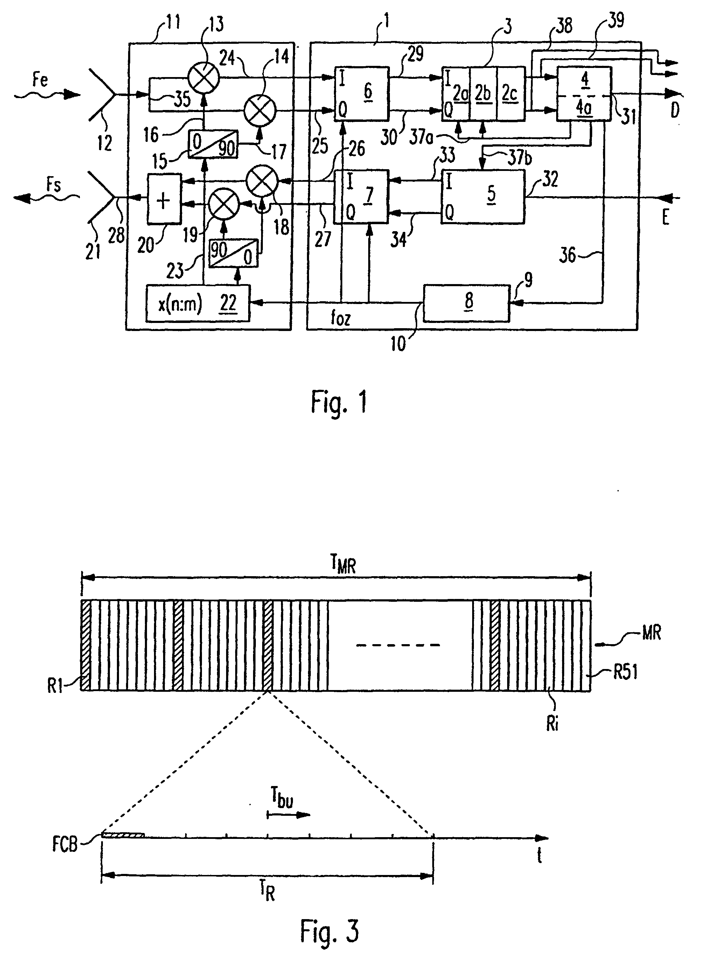

Nach Fig. 1 umfaßt eine für ein Kommunikationsendgerät, beispielsweise Mobilstation vorgesehene Schaltungsanordnung ein Hochfrequenzteil 11 und eine Signalverarbeitungsschaltung 1.

Das Hochfrequenzteil 11 weist eine Empfangsantenne 12 auf, welche ein Funkempfangssignal Fe empfängt, das zuvor von einer stationären Basisstation in einem vorgegebenen Frequenzkanal mit der Kanalmittenfrequenz $f_K$ ausgesendet wurde.

Ein von der Empfangsantenne 12 abgegebenes HF-Empfangssignal 35 wird einem ersten und einem zweiten Abwärtsmischer 13, 14 zugeleitet. Die Abwärtsmischer 13, 14 werden mit Mischfrequenzsignalen 16, 17 betrieben, die eine gleiche Mischfrequenz $f_M$ und eine Phasenverschiebung von 90° zueinander aufweisen.

Zur Erzeugung der Mischfrequenzsignale 16, 17 ist in der Signalverarbeitungsschaltung ein Oszillator 8 (VCO: voltagecontrolled oscillator) mit steuerbarer Oszillatorfrequenz $f_{Oz}$ vorgesehen. Die Oszillatorfrequenz $f_{Oz}$ kann beispielsweise 13 MHz betragen und steht an einem Ausgang 10 des VCO 8 bereit. Die Oszillatorfrequenz $f_{Oz}$ wird einem n:m-Frequenzvervielfacher 22 zugeführt, der ein Mischfrequenzsignal 23 der n:m-fachen Frequenz $f_M$ erzeugt, wobei n, m ganze Zahlen sind. Das Mischfrequenzsignal 23 wird einem 90°-Phasenschieber 15 zugeleitet, der die beiden um 90° gegeneinander phasenverschobenen Mischfrequenzsignale 16, 17 bereitstellt.

Die Abwärtsmischer 13, 14 erzeugen jeder ein analoges ZF-Empfangssignal 24 bzw. 25, welche einem I-(Inphase) bzw. einem Q-(Quadratur)-Eingang eines AD-Umsetzers 6 zugeführt werden.

Der AD-Umsetzer 6 tastet die beiden analogen ZF-Empfangssignale 24, 25 jeweils getrennt mit einer von der Oszillatorfrequenz $f_{Oz}$ abgeleiteten Abtastfrequenz $f_A$ ab und stellt an seinen Ausgängen jeweilige digitale Empfangssignale 29, 30 bereit. Zur Erhöhung der Umsetzgenauigkeit kann ein Überabtastverfahren mit $f_A = 2L \cdot f_{KB}$ angewendet werden, wobei $f_{KB}$ die Kanalbandbreite und L > 1 der gewählte Überabtastfaktor ist.

Die digitalen Empfangssignale 29, 30 werden I- und Q-Eingängen einer digitalen Multiratenschaltung 3 zugeführt.

Die Multiratenschaltung 3 kann ein Frequenzverschiebungsrechenwerk 2a, ein digitales Filter 2b und ein Abtastfrequenz-Reduzierwerk 2c aufweisen.

Das Frequenzverschiebungsrechenwerk 2a ermöglicht auf rechnerischem Wege eine Frequenzverschiebung der Spektren der einlaufenden digitalen Empfangssignale 29, 30.

Das digitale Filter 2b führt (ebenfalls auf rechnerischem Wege) eine Bandbreitenbegrenzung der - gegebenenfalls zuvor in ihrer Frequenz verschobenen - digitalen Empfangssignale 29, 30 durch. Hierfür weist das digitale Filter 2b einen Durchlaßbereich fest vorgegebener Durchlaß-Bandbreite $f_{FB}$ auf. Sofern es sich um ein Bandpaßfilter handelt, kann der Durchlaßbereich fester Bandbreite $f_{FB}$ wie im folgenden noch näher erläutert spektral verschiebbar sein. Bei dem digitalen Filter 2b kann es sich beispielsweise um ein Finite-Impulse-Response-(FIR-) oder Infinite-Impulse-Response-(IIR-) Bandpaß- oder - im Basisbandbereich - Tiefpaßfilter erster oder höherer Ordnung handeln.

Das Abtastfrequenz-Reduzierwerk 2c ist dem digitalen Filter 2b nachgeschaltet und führt gegebenenfalls eine Reduzierung der Abtastfrequenz um einen geeigneten Faktor L' durch. Das Abtastfrequenz-Reduzierwerk 2c dient dazu, die von der Multiratenschaltung 3 ausgegebenen gefilterten digitalen Empfangssignale 38, 39 ausgangsseitig mit einer Abtastfrequenz bereitzustellen, die in bezug auf Rechenaufwand und Rechengenauigkeit den in der nachfolgenden Datenverarbeitung bestehenden Erfordernissen angepaßt ist.

Die Multiratenschaltung 3 steht ausgangsseitig mit einem Kanalschätzer 4 in Datenverbindung. In dem Kanalschätzer 4 ist softwaremäßig ein Frequenzschätzer 4a implementiert.

Die Aufgabe des Kanalschätzers 4 besteht zum einen darin, anhand von in dem Funkempfangssignal Fe enthaltenen vorgegebenen Datensequenzen (Trainingssequenzen) fortlaufend aktuelle Kanalparameter (Impulsantworten) und auf deren Basis eine aktuelle Übertragungsfunktion des Mobilfunkkanals zu ermitteln. Die Übertragungsfunktion charakterisiert das momentane Übertragungsverhalten des Mobilfunkkanals. Sie muß ständig neu ermittelt werden, weil sich die Wellenausbreitung in der Luftschnittstelle des Mobilfunkkanals durch wechselnde Umgebungseinflüsse ständig ändert, was zur Folge hat, daß eine Datendetektion ohne Kenntnis der zugehörigen Übertragungsfunktion nicht möglich ist.

Die Datendetektion findet in einem Datendetektor D statt. Hierzu wird dem Datendetektor D das von der Multiratenschaltung 3 ausgegebene gefilterte digitale Empfangssignal 38, 39 sowie über einen Ausgang 31 des Kanalschätzers 4 die zugehörige aktuelle Übertragungsfunktion zur Verfügung gestellt.

Zum anderen ermittelt der Kanalschätzer 4 in erfindungsgemäßer Weise mittels des integrierten Frequenzschätzers 4a (bzw. der den Frequenzschätzer 4a repräsentierenden Software) ein erstes Frequenzkorrektur-Steuersignal 36 und zwei zweite Frequenzkorrektur-Steuersignale 37a, 37b. Das erste Frequenzkorrektur-Steuersignal 36 wird zur Steuerung der Oszillatorfrequenz $f_{Oz}$ einem Frequenzsteuereingang 9 des VCO 8 zugeführt. Eines der beiden zweiten Frequenzkorrektur-Steuersignale 37a wird dem Frequenzverschiebungsrechenwerk 2a und/oder dem digitalen Filter 2b der Multiratenschaltung 3 zugeleitet. Das andere zweite Frequenzkorrektur-Steuersignal 37b wird in einen digitalen I/Q-Modulator 5, der in dem im folgenden zu beschreibenden Sendeteil der erfindungsgemäßen Schaltungsanordnung untergebracht ist, eingespeist.

Dem digitalen I/Q-Modulator 5 wird über einen Eingang 32 ein zuvor gegebenenfalls quellencodiertes, kanalcodiertes und verschachteltes digitales Eingangssignal E zugeführt. Der digitale I/Q-Modulator 5 tastet das digitale Eingangssignal E gemäß einem vorgegebenen Modulationsverfahren, beispielsweise GMSK (Gaussian Minimum Shift Keying) um, wobei gleichzeitig eine Bandbreitenbegrenzung herbeigeführt wird. Ausgangsseitig stellt der I/Q-Modulator 5 einem DA-Umsetzer 7 zwei umgetastete (modulierte) digitale Eingangssignale 33, 34 (I- und Q-Zweig) zur Verfügung. Der DA-Umsetzer 7 wandelt die digitalen Eingangssignale 33, 34 in ein analoges I-Ausgangssignal 26 und ein analoges Q-Ausgangssignal 27 um.

Die HF-Sendestufe ist analog der HF-Empfangsstufe aufgebaut. Die beiden analogen I/Q-Ausgangssignale 26, 27 werden zwei 90°-phasenversetzt angesteuerten Aufwärtsmischern 18, 19 zugeführt, welche jeweils mit einer Mischfrequenz $f'_M$ betrieben werden. Die Mischfrequenz $f'_M$ wird von dem n:m-Frequenzvervielfacher 22 bereitgestellt. Die Ausgangssignale der Aufwärtsmischer 18, 19 werden einer Addierstufe 20 zugeleitet und dort zu einem HF-Sendesignal 28 überlagert. Das HF-Sendesignal 28 wird mittels einer Sendeantenne 21 als Funksendesignal Fs abgestrahlt.

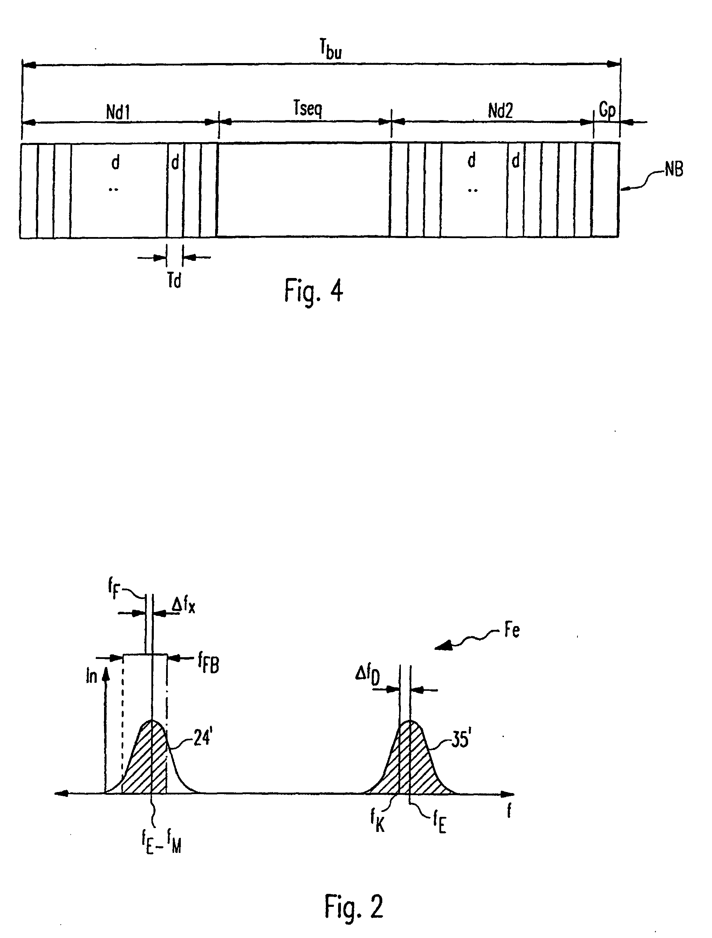

Fig. 2 zeigt ein Diagramm, in dem ein Spektrum 35' des HF-Empfangssignals 35 und ein Spektrum 24' des heruntergemischten analogen ZF-Empfangssignals 24 in qualitativer Weise dargestellt sind.

Das Funkempfangssignal Fe wird von der Basisstation in einem Teilnehmerkanal mit der Kanalmittenfrequenz $f_K$ ausgesendet. In dem hier betrachteten Fall bewegt sich die Mobilstation auf die Basisstation zu, wodurch die Mittenfrequenz $f_E$ des HF-Empfangssignalspektrums 35' gegenüber der Kanalmittenfrequenz $f_K$ um die entsprechende Doppler-Frequenzverschiebung $\Delta f_D$ zu höheren Frequenzen hin verschoben ist.

Der folgenden Betrachtung liegt die Annahme zugrunde, daß das digitale Filter 2 ein symmetrisches Bandpaßfilter mit der Durchlaß-Mittenfrequenz $f_F$ und der festen Durchlaß-Bandbreite $f_{FB}$ ist, und das Frequenzverschiebungsrechenwerk 2a keine Frequenzverschiebung der digitalen Empfangssignale 29 und 30 durchführt. Durch Mischung mit dem Mischfrequenzsignal 23 (oder auch 16, 17) der Frequenz $f_M$ wird ein ZF-Empfangssignal 24 der Mittenfrequenz $f_E - f_M$ erzeugt. Fig. 2 veranschaulicht die Situation für den Fall $f_M = f_K - f_F$, d.h. ohne Berücksichtigung der Doppler-Frequenzverschiebung $\Delta f_D$ bei der Abwärtsmischung. Die Mittenfrequenz des Signalspektrums 24' ist dann gegenüber der Durchlaß-Mittenfrequenz $f_F$ des digitalen Filters 2 um einen Frequenzversatz $\Delta f_X = \Delta f_D$ zu höheren Frequenzen hin verschoben.

Der im Durchlaßbereich (Bandbreite $f_{FB}$) des digitalen Filters 2 liegende Spektralanteil des ZF-Empfangssignals 24 ist in Fig. 2 schraffiert dargestellt. Es wird deutlich, daß die Fehlanpassung zwischen $f_F$ und $f_E - f_M$ eine Verschlechterung der Bandbreitenausnutzung und infolgedessen in nachteiliger Weise eine Verminderung des Signal-zu-Rausch Verhältnisses zur Folge hat.

Vorstehend wurde angenommen, daß $\Delta f_X = \Delta f_D$ gilt, d.h., daß die Doppler-Frequenzverschiebung $\Delta f_D$ alleinige Ursache für die Fehlanpassung des Spektrums 24' des ZF-Empfangssignals 24 an die Durchlaß-Mittenfrequenz $f_F$ des digitalen Filters 2 ist. Allgemein gilt jedoch $\Delta f_X \neq \Delta f_D$, da neben der Doppler-Frequenzverschiebung $\Delta f_D$ auch andere Einflüsse wie beispielsweise (langsame) Frequenzdrifts und (schnelle) Frequenzfluktuationen des VCO 8 (d.h. der Oszillatorfrequenz $f_{Oz}$) zu dem Frequenzversatz $\Delta f_X$ beitragen.

Während langsame Frequenzdrifts der Oszillatorfrequenz $f_{Oz}$ sowie der auf die Doppler-Frequenzverschiebung $\Delta f_D$ zurückgehende Teil des Frequenzversatzes $\Delta f_X$ durch das erste Frequenzkorrektur-Steuersignal 36 ausgeregelt werden können, ermöglichen die beiden zweiten Frequenzkorrektur-Steuersignale 37a, 37b die Ausregelung von schnellen Frequenzfluktuationen der Oszillatorfrequenz $f_{Oz}$.

Der für beide Frequenzkorrektur-Steuersignale 36 und 37a, 37b im Frequenzschätzer 4a zu bestimmende Frequenzversatz $\Delta f_X$ kann beispielsweise nach dem Verfahren der Momentberechnung geschätzt werden. Dieses Verfahren wird im folgenden näher erläutert:

Man betrachte N diskrete komplexe Werte einer Empfangsfolge

$$\vec{e} = \left( \underline{e}_1, \underline{e}_2, \ldots, \underline{e}_N \right)$$

des gefilterten digitalen Empfangssignals 38 bzw. 39.

Die normierte Frequenz $\tilde{f}$ wird durch den Ausdruck

$$\tilde{f} = f \cdot \frac{T_b}{N} \qquad\qquad (1)$$

definiert, wobei f der in Fig. 2 dargestellten Frequenz $f_E - f_M$ des heruntergemischten ZF-Empfangssignals 24 entspricht und $T_b$ die Beobachtungszeit (d.h. die Zeit, über die die N Werte $\underline{e}_n$ gesammelt werden) ist.

Jeder Wert $\underline{e}_n$ der Empfangsfolge

$$\vec{e} = \left( \underline{e}_1, \ \underline{e}_2, \ \ldots, \ \underline{e}_N \right)$$

kann durch die Gleichung

$$\underline{e}_n = A_n \cdot \exp(j\varphi_0) \cdot \exp(j2\pi\tilde{f}n) + \underline{n}_n \qquad (2)$$

ausgedrückt werden. Dabei bezeichnet $A_n \cdot \exp(j\varphi_0)$ die komplexwertige Amplitude und $\underline{n}_n$ einen auf weißes Rauschen der Gaußbreite $\sigma$ zurückgehenden Rauschanteil von $\underline{e}_n$.

Das in der Empfangsfolge $\vec{e}$ enthaltene Nutzsignal wird als Nutzsignalfolge

$$\vec{\underline{s}} = \left( \underline{s}_1, \ \underline{s}_2, \ \ldots, \ \underline{s}_N \right) \quad \text{mit} \quad \underline{s}_n = A_n \cdot \exp(j\varphi_0) \cdot \exp(j2\pi\tilde{f}n) \qquad (3)$$

geschrieben.

Die Autokorrelationsfunktion des Nutzsignals ergibt sich zu

$$\begin{aligned} \underline{r}_{\underline{s}nk} &= E\{\underline{s}_n \cdot \underline{s}^*_{n+k}\} \\ &= E\{A_n \cdot A_{n+k}\} \cdot \exp(-j2\pi\tilde{f}k) \end{aligned} \qquad (4)$$

wobei

$$E\{\underline{s}_n \cdot \underline{s}^*_{n+k}\}$$

der Erwartungswert des Produktes der als Zufallsgrößen aufgefaßten Werte von $\underline{s}_n$ und $\underline{s}^*_{n+k}$ ist (konjungiert komplexe Ausdrücke sind mit einem * gekennzeichnet).

Die Autokorrelationsfunktion des gefilterten digitalen Empfangssignals 38, 39 hat die Form:

$$\underline{r}_{\underline{e}nk} = E\{A_n \cdot A_{n+k}\} \cdot \exp(-j2\pi\tilde{f}k) + \sigma^2 \cdot \delta_{nk}. \qquad (5)$$

Für $k = 1$ ergibt sich

$$\begin{aligned} \underline{r}_{\underline{e}n1} &= \exp(-j2\pi\tilde{f}) \cdot E\{A_n \cdot A_{n+1}\} \\ &= \{\cos(2\pi\tilde{f}) - j\sin(2\pi\tilde{f})\} \cdot E\{A_n \cdot A_{n+1}\} \end{aligned} \qquad (6)$$

Mit der Abkürzung $\sigma_A^2 = E\{A_n \cdot A_{n+1}\}$ folgt

$$\tilde{f} = \frac{1}{4\pi} \cdot \left\{ \arccos\left\{ \frac{\operatorname{Re}\{\underline{r}_{\underline{e}n1}\}}{\sigma_A^2} \right\} - \arcsin\left\{ \frac{\operatorname{Im}\{\underline{r}_{\underline{e}n1}\}}{\sigma_A^2} \right\} \right\} \qquad (7)$$

Eine gute Schätzung für die Autokorrelationsfunktion ist

$$\hat{\tilde{f}}_{e_{n1}} \approx \frac{1}{N-1} \sum_{n=1}^{N-1} \underline{e}_n \cdot \underline{e}_{n+1}^{\star} \tag{8}$$

Einsetzen von (8) in (7) führt zu:

$$\hat{\tilde{f}} = -\frac{1}{2\pi} \cdot \arctan\left\{\frac{\text{Im}\left\{\frac{1}{N-1} \sum_{n=1}^{N-1} \underline{e}_n \cdot \underline{e}_{n+1}^{\star}\right\}}{\text{Re}\left\{\frac{1}{N-1} \sum_{n=1}^{N-1} \underline{e}_n \cdot \underline{e}_{n+1}^{\star}\right\}}\right\} \tag{9}$$

Hierbei ist $\hat{\tilde{f}}$ ein aus N Werten der Empfangsfolge $\vec{\underline{e}}$ gewonnener Schätzwert für die normierte Frequenz $\tilde{f}$. Nach Gleichung (1) ergibt sich aus $\hat{\tilde{f}}$ ein Schätzwert f für die Frequenz f und aus dem Schätzwert f folgt ein Schätzwert $\Delta f_X$ für den Frequenzversatz $\Delta f_X$.

Für die Berechnung der ersten und zweiten Frequenzkorrektur-Steuersignale 36 und 37a, 37b wird $\hat{\tilde{f}}$ und damit auch $\Delta f_X$ mit unterschiedlichen Wiederholungsraten und für unterschiedliche N ermittelt. Dies wird im folgenden anhand der Fig. 3 und 4 erläutert.

Fig. 3 zeigt einen Mehrfachrahmen MR, der in dem GSM-Standard als größtmögliche Einheit zur Strukturierung von Datensymbolen Verwendung findet. Der Mehrfachrahmen MR besteht aus 51 TDMA-Rahmen R1, ..., R51, die in dem Mehrfachrahmen MR in aufsteigender Reihenfolge von 1 bis 51 durchnumeriert sind. Jeder TDMA-Rahmen Ri, i = 1, ..., 51 weist eine Rahmendauer $T_R$ = 4,61 ms auf. Die Dauer des Mehrfachrahmens MR beträgt demzufolge etwa $T_{MR}$ = 235 ms.

Jeder TDMA-Rahmen Ri ist in acht Zeitschlitze der Dauer $T_{bu}$ unterteilt. Die Zeitschlitze sind jeweils unterschiedlichen Teilnehmern zugeteilt. Dadurch können in einem Verkehrskanal maximal acht Teilnehmer Daten mit einer gemeinsamen Basisstation austauschen.

In jedem Zeitschlitz wird ein Block bestehend aus (etwa) 156 Symbolen (Bits) übertragen.

Es gibt mehrere Arten von Blöcken, die sich durch eine unterschiedliche Symbolstruktur unterscheiden. Einer dieser Blökke ist der Frequenzkorrekturblock FCB. Der FCB wird jeweils in dem ersten Zeitschlitz der TDMA-Rahmen R1, R11, R21, R31 und R41 gesendet und weist die Besonderheit auf, daß sämtliche Symbole den logischen Wert 0 besitzen. Das gesendete Signal ist demzufolge eine reine Sinusschwingung einer festen Frequenz, (die aus Gründen, die für die vorliegende Erfindung nicht weiter von Bedeutung sind, nicht genau die Kanalmittenfrequenz $f_K$ ist sondern gegenüber dieser um eine feste Frequenzverschiebung von 1625kHz/24 = 67,7 kHz verschoben ist).

Aus dem Vorstehenden folgt, daß der FCB etwa alle 46 ms gesendet wird. Bei jedem Empfang eines FCB ermittelt der Frequenzschätzer 4a einen Schätzwert $\Delta f_X$ für den tatsächlichen Frequenzversatz $\Delta f_X$ und erzeugt daraufhin das erste Frequenzkorrektur-Steuersignal 36. Erfindungsgemäß wird die Mischfrequenz $f_M$ durch Beaufschlagung des VCO 8 mit dem ersten Frequenzkorrektur-Steuersignal 36 so eingestellt, daß die Mittenfrequenz des Spektrums 24' des analogen ZF-Eingangssignals 24 mit der Durchlaß-Mittenfrequenz $f_F$ des Filters 2 zusammenfällt, d.h. $\Delta f_X = (f_E - f_M) - f_F = 0$ gilt. Dadurch werden langsame Frequenzänderungen nachgeregelt.

Fig. 4 zeigt die Struktur eines Nachrichtenblocks NB, wie er für die Übertragung der Nachrichtendaten verwendet wird. Der Nachrichtenblock NB ist im wesentlichen aus einem ersten Nachrichten-Datenteil Nd1, einer Trainingssequenz Tseq, einem zweiten Nachrichten-Datenteil Nd2 und einer Schutzzeit Gp aufgebaut. Die Trainingssequenz Tseq ist in jedem Nachrichtenblock NB die gleiche und umfaßt 26 Symbole. Die Symbolzeitdauer $T_d$ beträgt etwa 3,7 μs.

Die Trainingssequenz Tseq ist dem Kanalschätzer 4 bekannt und wird von diesem wie bereits beschrieben zur Ermittlung der Übertragungsfunktion des Mobilfunkkanals verwendet. Für jeden Nachrichtenblock NB wird eine neue Übertragungsfunktion geschätzt.

Darüber hinaus ermittelt der Kanalschätzer 4 mittels des integrierten Frequenzschätzers 4a in erfindungsgemäßer Weise fortlaufend die zweiten Frequenzkorrektur-Steuersignale 37a, 37b, die für den momentanen Frequenzversatz $\Delta f_X$ zwischen der spektralen Mittenfrequenz $f_E - f_M$ der analogen ZF-Empfangssignale 24, 25 und der Durchlaß-Mittenfrequenz $f_F$ des digitalen Filters 2 repräsentativ sind.

Die Ermittlung der zweiten Frequenzkorrektur-Steuersignale 37a, 37b kann blockweise, d.h. mit der gleichen Rate (etwa alle 4,6 ms) wie die Ermittlung der Übertragungsfunktion erfolgen. In diesem Fall kann der Schätzung des Frequenzversatzes $\Delta f_X$ (durch Berechnung von $\Delta f_X$) genauso wie der Ermittlung der Kanal-Übertragungsfunktion die Trainingssequenz Tseq zugrundegelegt werden.

Es ist aber auch möglich, eine wesentlich höhere Rate für die Ermittlung der zweiten Frequenzkorrektur-Steuersignale 37a, 37b vorzusehen. Die größtmögliche zeitliche Auflösung wird bei einer symbolbasierten Ermittlung erreicht, bei der pro Symbolzeitdauer $T_d$ eine Neuermittlung der zweiten Frequenzkorrektur-Steuersignale 37a, 37b, - d.h. eine Neuberechnung von $\Delta f_x$ - stattfindet. Um eine ausreichende Genauigkeit bei der Schätzung des Frequenzversatzes $\Delta f_x$ zu erzielen, müssen innerhalb der Symbolzeitdauer $T_d$ dann eine hinreichend große Anzahl N von Werten der Empfangsfolge $\vec{e}$ zur Verfügung stehen. Dies bedeutet, daß für eine hinreichend hohe Überabtastung (großer Überabtastfaktor L) der ZF-Empfangssignale 24, 25 im AD-Umsetzer 6 zu sorgen ist, und daß diese Abtastrate in dem nachfolgenden Abtastraten-Reduzierwerk 2c nicht wesentlich reduziert werden darf (d.h. beispielsweise Faktor L' = 1).

Mittels der zweiten Frequenzkorrektur-Steuersignale 37a, 37b werden schnelle Frequenzfluktuationen (d.h. Phasenrauschen) des VCO 8 ausgeregelt, für die die beschriebene Regelung über das erste Frequenzkorrektur-Steuersignal 36 (beispielsweise etwa alle 46 ms) zu langsam ist. Fluktuationen der Oszillatorfrequenz $f_{Oz}$ treten im Zeitbereich von ungefähr 100 Oszillatorschwingungen auf. Bei einer Oszillatorfrequenz $f_{Oz}$ = 13 MHz beträgt die für eine Fluktuation typische Zeitdauer beispielsweise etwa 8 μs und ist damit länger als die Symbolzeitdauer $T_d$.

Im Empfangsteil der Mobilstation kann die Ausregelung der Frequenzfluktuationen auf zwei unterschiedliche Weisen erfolgen: Zum einen durch das Frequenzverschiebungsrechenwerk 2a, mittels dem die Frequenz der digitalen Empfangssignale 29, 30 auf die Mittenfrequenz $f_F$ des digitalen Filters 2b eingestellt werden kann. Eine andere, äquivalente Möglichkeit besteht darin, ohne eine vorherige Frequenzverschiebung der digitalen Empfangssignale 29, 30 die Mittenfrequenz $f_F$ des digitalen Filters 2b fortlaufend auf die Frequenz der digitalen Empfangssignale 29, 30 nachzustellen. Wenn die Filterung durch das digitale Filter 2 im Basisband erfolgt, d.h. das digitale Filter 2 als Tiefpaßfilter ausgebildet ist, kann der Frequenzversatz $\Delta f_x$ nur nach der ersten Möglichkeit korrigiert werden.

Auf der Sendeseite der Mobilstation sind die genannten Effekte (Doppler-Frequenzverschiebung $\Delta f_D$, Frequenzdrifts und Frequenzfluktuationen des VCOs 8) gleichfalls zu berücksichtigen, da das Funksendesignal Fs an der Basisstation einer kanalbegrenzenden Filterung symmetrisch zu der Kanalmittenfrequenz $f_K$ unterzogen wird. Demnach ist die Mischfrequenz $f'_M$ gegenüber der nominalen Mischfrequenz mittels des ersten Frequenzkorrektur-Steuersignals 36 in analoger Weise wie bei der Empfangsstufe zu korrigieren. Ferner werden die schnellen Frequenzfluktuationen des VCO 8 mittels des zweiten Frequenzkorrektur-Steuersignals 37b im I/Q-Modulator 5 durch eine entsprechende Korrektur bei der Berechnung (Synthetisierung) der digitalen modulierten Signale 33, 34 ausgeglichen.

Bezugszeichenliste

| | |
|---|---|
| 1 | Signalverarbeitungsschaltung |
| 2a | Frequenzverschiebungsrechenwerk |
| 2b | digitales Filter |
| 2c | Abtastfrequenz-Reduzierrechenwerk |
| 3 | Multiratenschaltung |
| 4 | Kanalschätzer |
| 4a | Frequenzschätzer |
| 5 | I/Q-Modulator |
| 6 | AD-Umsetzer |
| 7 | DA-Umsetzer |
| 8 | VCO |
| 9 | Steuereingang |
| 10 | Oszillatorausgang |
| 11 | Hochfrequenzteil |
| 12 | Empfangsantenne |
| 13 | erster Abwärtsmischer |
| 14 | zweiter Abwärtsmischer |
| 15 | 90°-Phasenschieber |
| 16 | Mischfrequenzsignal |
| 17 | Mischfrequenzsignal |
| 18 | Aufwärtsmischer |
| 19 | Aufwärtsmischer |
| 20 | Addierstufe |
| 21 | Sendeantenne |
| 22 | n:m Prequenzvervielfacher |
| 23 | Mischfrequenzsignal |

| 24 | analoges ZF-Empfangssignal |
|---|---|
| 24' | Frequenzspektrum des ZF-Empfangssignals |
| 25 | analoges ZF-Empfangssignal |
| 26 | I-Ausgangssignal |
| 27 | Q-Ausgangssignal |
| 28 | HF-Sendesignal |
| 29 | digitales Empfangssignal |
| 30 | digitales Empfangssignal |
| 31 | Ausgang des Kanalschätzers |
| 32 | Eingang des I/Q-Modulators |
| 33 | digitales Eingangssignal |
| 34 | digitales Eingangssignal |
| 35 | HF-Empfangssignal |
| 35' | Frequenzspektrum des HF-Empfangssignals |
| 36 | erstes Frequenzkorrektur-Steuersignal |
| 37a,b | zweite Frequenzkorrektur-Steuersignale |
| 38 | gefiltertes digitales Empfangssignal |
| 39 | gefiltertes digitales Empfangssignal |

| D | Datendetektor |
|---|---|
| E | Eingangssignal |
| Fe | Funkempfangssignal |
| Fs | Funksendesignal |

| $f_K$ | Kanalmittenfrequenz |
|---|---|
| $f_{KB}$ | Kanalbandbreite |
| $f_M$, $f'_M$ | Mischfrequenz |
| $f_E$ | Empfangsfrequenz |
| $f_F$ | Durchlaßmittenfrequenz des Filters |
| $f_{FB}$ | Durchlaßbandbreite des Filters |
| $\Delta f_D$ | Doppler-Frequenzverschiebung |
| $\Delta f_X$ | Frequenzversatz |

| L,L' | Uberabtastfaktoren |
|---|---|
| MR | Mehrfachrahmen |
| Ri | i-ter TDMA-Rahmen |
| FCB | Frequenzkorrekturblock |
| NB | Nachrichtenblock |
| Gp | Schutzzeitsequenz |
| Nd1,2 | Nachrichtendatensequenz |
| Tseq | Trainingssequenz |
| d | Symbol |
| $T_{MR}$ | Zeitdauer eines Mehrfachrahmens |
| $T_R$ | Zeitdauer eines Rahmens |
| $T_{bu}$ | Zeitdauer eines Blocks |
| $T_d$ | Zeitdauer eines Symbols |

**Patentansprüche**

1. Schaltungsanordnung, die

- ein Hochfrequenzteil (11) mit einer Empfangsmischstufe (13, 14), das ein HF-Empfangssignal (35) entgegennimmt und das HF-Empfangssignal (35) durch Heruntermischen mit einer einstellbaren Mischfrequenz ($f_M$) in ein analoges ZF-Empfangssignal (24, 25) umsetzt, und
- eine Signalverarbeitungsschaltung (1) mit

-- einem AD-Umsetzer (6), welcher das analoge ZF-Empfangssignal (24, 25) in ein digitales Empfangssignal (29, 30) umsetzt,
- -- einem dem AD-Umsetzer (6) nachgeschalteten digitalen Filter (2), das ein gefiltertes digitales Empfangssignal (38, 39) ausgibt und
- -- einem Frequenzschätzer (4a), der das gefilterte digitale Empfangssignal (38, 39) entgegennimmt,

umfaßt, wobei

- der Frequenzschätzer (4a) fortlaufend ein erstes Frequenzkorrektur-Steuersignal (36) ermittelt, das für einen Frequenzversatz ($\Delta f_X$) zwischen der Frequenz des analogen ZF-Empfangssignals (24, 25) und einer für einen Durchlaßbereich des verwendeten digitalen Filters (2) charakteristischen Frequenz ($f_F$) repräsentativ ist, und
- das erste Frequenzkorrektur-Steuersignal (36) zur Nachstellung der Mischfrequenz ($f_M$) verwendet wird,

**dadurch gekennzeichnet,**

- **daß** die Signalverarbeitungsschaltung (1) einen die Übertragungsfunktion eines Punkkanals schätzenden Kanalschätzer (4) umfaßt, und
- **daß** der Frequenzschätzer (4a) in dem Kanalschätzer (4) enthalten ist.

2. Schaltungsanordnung nach Anspruch 1,
**dadurch gekennzeichnet,**

- **daß** die Signalverarbeitungsschaltung (1) ferner einen digitalen Modulator (5) und einen DA-Umsetzer (7) aufweist,
- **daß** das Hochfrequenzteil (11) eine Sendemischstufe (18, 19) aufweist, und
- **daß** ein von dem digitalen Modulator (5) erzeugtes und von dem DA-Umsetzer (7) ausgegebenes analoges Sendesignal (26, 27) dem Hochfrequenzteil (11) zugeführt und in der Sendemischstufe (18, 19) durch Heraufmischen mit einer gemäß dem ersten Frequenzkorrektur-Steuersignal (36) eingestellten weiteren Mischfrequenz ($f'_M$) in ein HF-Sendesignal (28) umgesetzt wird.

3. Schaltungsanordnung nach Anspruch 1 oder 2,
**dadurch gekennzeichnet**

- **daß** die Schaltungsanordnung einen Oszillator (VCO, 8) mit steuerbarer Oszillatorfrequenz ($f_{Oz}$) umfaßt,
- **daß** das erste Frequenzkorrektur-Steuersignal (36) dem Oszillator (VCO, 8) zur Steuerung der Oszillatorfrequenz ($f_{Oz}$) zugeführt wird, und
- daß die Mischfrequenz ($f_M$) und/oder die weitere Mischfrequenz ($f'_M$) von der gesteuerten Oszillatorfrequenz ($f_{Oz}$). abgeleitet wird.

4. Schaltungsanordnung nach einem der vorhergehenden Ansprüche,
**dadurch gekennzeichnet,**

- **daß** ein von einer Basisstation gesendetes Funkempfangssignal (Fe) einen zeitlich wiederkehrenden Frequenzkorrekturblock-Signalanteil (FCB) in Form einer Sinusschwingung enthält, und
- **daß** der Frequenzschätzer (4a) den Frequenzversatz ($\Delta f_X$) mittels einer Auswertung eines Signalanteils des gefilterten digitalen Empfangssignals (38, 39) schätzt, dem der Frequenzkorrekturblock-Signalanteil (FCB) des Funkempfangssignals (Fe) zugrundeliegt.

5. Schaltungsanordnung nach Anspruch 4,
**dadurch gekennzeichnet,**
**daß** der Frequenzkorrekturblock-Signalanteil (FCB) alle 10 bis 100 ms von der Basisstation gesendet wird.

6. Schaltungsanordnung, die

- ein Hochfrequenzteil (11) mit einer Empfangsmischstufe (13, 14), das ein HF-Empfangssignal (35) entgegennimmt und das HF-Empfangssignal (35) durch Heruntermischen in ein analoges ZF-Empfangssignal (24, 25) umsetzt, und
- eine Signalverarbeitungsschaltung (1) mit

-- einem AD-Umsetzer (6), welcher das analoge ZF-Empfangssignal (24, 25) in ein digitales Empfangssignal (29, 30) umsetzt,

-- einem dem AD-Umsetzer (6) nachgeschalteten digitalen Filter (2), das ein gefiltertes digitales Empfangssignal (38, 39) ausgibt und

-- einem Frequenzschätzer (4a), der das gefilterte digitale Empfangssignal (38, 39) entgegennimmt,

umfaßt,
**dadurch gekennzeichnet,**

- **daß** der Frequenzschätzer (4a) fortlaufend ein zweites Frequenzkorrektur-Steuersignal (37a, 37b) ermittelt, das für einen Frequenzversatz ($\Delta f_X$) zwischen der Frequenz des analogen ZF-Empfangssignals (24, 25) und einer für einen Durchlaßbereich des verwendeten digitalen Filters (2) charakteristischen Frequenz ($f_F$) repräsentativ ist, und

- **daß** das zweite Frequenzkorrektur-Steuersignal (37a, 37b) zu einer spektralen Nachbearbeitung des digitalen Empfangssignals (29, 30) vor dem digitalen Filter (2) und/oder zu einer Nachstellung des Durchlaßbereichs des digitalen Filters (2) verwendet wird.

7. Schaltungsanordnung nach Anspruch 6,
**dadurch gekennzeichnet,**

- **daß** die Signalverarbeitungsschaltung ferner einen digitalen Modulator (5) und einen DA-Umsetzer (7) aufweist, wobei ein von dem digitalen Modulator (5) bereitgestelltes moduliertes digitales Sendesignal (33, 34) von dem DA-Umsetzer (7) in ein analoges Sendesignal (26, 27) umgesetzt wird,

- **daß** das zweite Frequenzkorrektur-Steuersignal (37b) dem digitalen Modulator (5) zugeführt wird, und

- **daß** der digitale Modulator (5) die Frequenz des erzeugten modulierten digitalen Sendesignals (33, 34) in Abhängigkeit von dem zweiten Frequenzkorrektur-Steuersignal (37b) verändert.

8. Schaltungsanordnung nach einem der vorhergehenden Ansprüche,
**dadurch gekennzeichnet,**
**daß** der Frequenzschätzer (4a) zur Schätzung des Frequenzversatzes ($\Delta f_X$) das Verfahren der Momentberechnung anwendet.

9. Schaltungsanordnung nach einem der Ansprüche 6 bis 8,
**dadurch gekennzeichnet,**

- **daß** die Signalverarbeitungsschaltung (1) einen die Übertragungsfunktion eines Funkkanals schätzenden Kanalschätzer (4) umfaßt, und

- **daß** der Frequenzschätzer (4a) in dem Kanalschätzer (4) enthalten ist.

10. Schaltungsanordnung nach einem der Ansprüche 6 bis 9,
**dadurch gekennzeichnet,**
**daß** der Frequenzschätzer (4a) für jedes Datensymbol (d) des gefilterten digitalen Empfangssignals (38, 39) jeweils eine Neuermittlung des zweiten Frequenzkorrektur-Steuersignals (37a, 37b) durchführt.

11. Schaltungsanordnung nach einem der Ansprüche 6 bis 9,
**dadurch gekennzeichnet,**

- **daß** das gefilterte digitale Empfangssignal (38, 39) in Blöcke (NB) bestehend aus einer vorgegebenen Anzahl von Datensymbolen (d) unterteilt ist, und

- **daß** der Frequenzschätzer (4a) für jeden Block (NB) des gefilterten digitalen Empfangssignals (38, 39) jeweils eine Neuermittlung des zweiten Frequenzkorrektur-Steuersignals (37a, 37b) durchführt.

**Claims**

1. Circuit arrangement, which has

- a radio-frequency section (11) with a reception mixing stage (13, 14), which receives an RF received signal (35) and converts the RF received signal (35) to an analog IF received signal (24, 25) by down-mixing with an adjustable mixing frequency ($f_M$), and

- a signal processing circuit (1) having

   - - an A/D converter (6) which converts the analog IF received signal (24, 25) to a digital received signal (29, 30),
   - - a digital filter (2) which is connected downstream from the A/D converter (6) and emits a filtered digital received signal (38, 39), and
   - - a frequency estimator (4a) which receives the filtered digital received signal (38, 39),

wherein

- the frequency estimator (4a) continuously determines a first frequency correction control signal (36) which is representative of a frequency offset ($\Delta f_x$) between the frequency of the analog IF received signal (24, 25) and a frequency ($f_F$) which is characteristic of a pass band of the digital filter (2) that is used, and
- the first frequency correction control signal (36) is used for readjustment of the mixing frequency ($f_M$),

**characterized**

- **in that** the signal processing circuit (1) has a channel estimator (4) which estimates the transfer function of a radio channel, and
- **in that** the frequency estimator (4a) is contained in the channel estimator (4).

2. Circuit arrangement according to Claim 1,
**characterized**

- **in that** the signal processing circuit (1) furthermore has a digital modulator (5) and a D/A converter (7),
- **in that** the radio-frequency section (11) has a transmission mixing stage (18, 19), and
- **in that** an analog transmission signal (26, 27), which is produced by the digital modulator (5) and is emitted from the D/A converter (7), is supplied to the radio frequency section (11) and is converted to an RF transmission signal (28) in the transmission mixing stage (18, 19) by up-mixing with a further mixing frequency ($f'_M$) which is set as a function of the first frequency correction control signal (36).

3. Circuit arrangement according to Claim 1 or 2,
**characterized**

- **in that** the circuit arrangement has an oscillator (VCO, 8) with a controllable oscillator frequency ($f_{Oz}$),
- **in that** the first frequency correction control signal (36) is supplied to the oscillator (VCO, 8) in order to control the oscillator frequency ($f_{Oz}$), and
- **in that** the mixing frequency ($f_M$) and/or the further mixing frequency ($f'_M$) are/is derived from the controlled oscillator frequency ($f_{Oz}$).

4. Circuit arrangement according to one of the preceding claims,
**characterized**

- **in that** a radio received signal (Fe), which is transmitted by a base station, contains a frequency correction burst signal component (FCB), which recurs cyclically, in the form of a sinusoidal oscillation, and
- **in that** the frequency estimator (4a) estimates the frequency offset ($\Delta f_x$) by evaluation of a signal component of the filtered digital received signal (38, 39), on which the frequency correction burst signal component (FCB) of the radio received signal (Fe) is based.

5. Circuit arrangement according to Claim 4,
**characterized**
**in that** the frequency correction burst signal component (FCB) is transmitted by the base station every 10 to 100 ms.

6. Circuit arrangement, which has

- a radio-frequency section (11) with a reception mixing stage (13, 14), which receives an RF received signal (35) and converts the RF received signal (35) by downmixing to an analog IF received signal (24, 25), and
- a signal processing circuit (1) having

- - an A/D converter (6) which converts the analog IF received signal (24, 25) to a digital received signal (29, 30),
- - a digital filter (2) which is connected downstream from the A/D converter (6) and emits a filtered digital received signal (38, 39), and
- - a frequency estimator (4a) which receives the filtered digital received signal (38, 39),

**characterized**

- **in that** the frequency estimator (4a) continuously determines a second frequency correction control signal (37a, 37b) which is representative of a frequency offset ($\Delta f_x$) between the frequency of the analog IF received signal (24, 25) and a frequency ($f_F$) which is characteristic of a pass band of the digital filter (2) that is used, and
- **in that** the second frequency correction control signal (37a, 37b) is used for spectral reprocessing of the digital received signal (29, 30) upstream of the digital filter (2) and/or for readjustment of the pass band of the digital filter (2).

7. Circuit arrangement according to Claim 6,
   **characterized**

   - **in that** the signal processing circuit furthermore has a digital modulator (5) and a D/A converter (7), with a modulated digital transmission signal (33, 34), which is provided by the digital modulator (5), being converted by the D/A converter (7) to an analog transmission signal (26, 27),
   - **in that** the second frequency correction control signal (37b) is supplied to the digital modulator (5), and
   - **in that** the digital modulator (5) changes the frequency of the modulated digital transmission signal (33, 34) which is produced, as a function of the second frequency correction control signal (37b).

8. Circuit arrangement according to one of the preceding claims,
   **characterized**
   **in that** the frequency estimator (4a) uses the moment calculation method in order to estimate the frequency offset ($\Delta f_X$).

9. Circuit arrangement according to one of Claims 6 to 8,
   **characterized**

   - **in that** the signal processing circuit (1) has a channel estimator (4) which estimates the transfer function of a radio channel, and
   - **in that** the frequency estimator (4a) is contained in the channel estimator (4).

10. Circuit arrangement according to one of Claims 6 to 9,
    **characterized**
    **in that** the frequency estimator (4a) in each case redetermines the second frequency correction control signal (37a, 37b) for each data symbol (d) in the filtered digital received signal (38, 39).

11. Circuit arrangement according to one of Claims 6 to 9,
    **characterized**

    - **in that** the filtered digital received signal (38, 39) is subdivided into bursts (NB) comprising a predetermined number of data symbols (d), and
    - **in that** the frequency estimator (4a) in each case redetermines the second frequency correction control signal (37a, 37b) for each burst (NB) in the filtered digital received signal (38, 39).

**Revendications**

1. Circuit, qui comprend

- une partie haute fréquence (11) avec un étage mélangeur de réception (13, 14) qui accepte un signal reçu HF (35) et qui convertit le signal reçu HF (35) par mélange abaisseur avec une fréquence de battement réglable ($f_M$) en un signal reçu ZF analogique (24, 25), et
- un circuit de traitement de signal (1) avec

  -- un convertisseur AD (6) qui convertit le signal reçu ZF analogique (24, 25) en un signal reçu numérique (29, 30),
  -- un filtre numérique (2) qui est branché du côté aval du convertisseur AD (6) et qui délivre un signal reçu numérique filtré (38, 39) et
  -- un estimateur de fréquence (4a) qui reçoit le signal reçu numérique filtré (38, 39),

et dans lequel

- l'estimateur de fréquence (4a) détermine en continu un premier signal de commande de correction de fréquence (36) qui est représentatif d'un décalage de fréquence ($\Delta f_X$) entre la fréquence du signal reçu ZF analogique (24, 25) et une fréquence ($f_F$) caractéristique d'une bande passante du filtre numérique utilisé (2), et
- le premier signal de commande de correction de fréquence (36) est utilisé pour l'ajustage de la fréquence de battement ($f_M$),

    **caractérisé par le fait que**

- le circuit de traitement de signal (1) comprend un estimateur de canal (4) estimant la fonction de transmission d'un canal radio, et
- l'estimateur de fréquence (4a) est contenu dans l'estimateur de canal (4).

2. Circuit selon la revendication 1,
    **caractérisé par le fait que**

- le circuit de traitement de signal (1) comporte en plus un modulateur numérique (5) et un convertisseur DA (7),
- la partie haute fréquence (11) comporte un étage mélangeur d'émission (18, 19), et
- un signal émis analogique (26, 27) produit par le modulateur numérique (5) et délivré par le convertisseur DA (7) est envoyé à la partie haute fréquence (11) et est converti dans l'étage mélangeur d'émission (18, 19), par un mélange élévateur avec une autre fréquence de battement ($f'_M$) réglée selon le premier signal de commande de correction de fréquence (36), en un signal émis HF (28).

3. Circuit selon la revendication 1 ou 2,
    **caractérisé par le fait que**

- le circuit comprend un oscillateur (VCO, 8) avec fréquence d'oscillateur commandable ($f_{Oz}$),
- le premier signal de commande de correction de fréquence (36) est envoyé à l'oscillateur (VCO, 8) pour la commande de la fréquence d'oscillateur ($f_{Oz}$), et
- la fréquence de battement ($f_M$) et/ou l'autre fréquence de battement ($f'_M$) sont déduites de la fréquence d'oscillateur commandée ($f_{Oz}$).

4. Circuit selon l'une des revendications précédentes,
    **caractérisé par le fait que**

- un signal reçu radio (Fe) émis par une station de base contient une composante de signal de bloc de correction de fréquence (FCB) revenant dans le temps sous la forme d'une oscillation sinusoïdale, et
- l'estimateur de fréquence (4a) estime le décalage de fréquence ($\Delta f_X$) au moyen d'une évaluation d'une composante du signal reçu numérique filtré (38, 39) à la base de laquelle se trouve la composante de signal de bloc de correction de fréquence (FCB) du signal reçu radio (Fe).

5. Circuit selon la revendication 4,
    **caractérisé par le fait que**
    la composante de signal de bloc de correction de fréquence (FCB) est émise par la station de base toutes les 10 à 100 ms.

**6.** Circuit qui comprend

- une partie haute fréquence (11) avec un étage mélangeur de réception (13, 14) qui accepte un signal reçu HF (35) et qui convertit le signal reçu HF (35) par mélange abaisseur en un signal reçu ZF analogique (24, 25), et
- un circuit de traitement de signal (1) avec

  - - un convertisseur AD (6) qui convertit le signal reçu ZF analogique (24, 25) en un signal reçu numérique (29, 30),
  - - un filtre numérique (2) qui est branché du côté aval du convertisseur AD (6) et qui délivre un signal reçu numérique filtré (38, 39), et
  - - un estimateur de fréquence (4a) qui reçoit le signal reçu numérique filtré (38, 39),

    **caractérisé par le fait que**

- l'estimateur de fréquence (4a) détermine en continu un deuxième signal de commande de correction de fréquence (37a, 37b) qui est représentatif d'un décalage de fréquence ($\Delta f_X$) entre la fréquence du signal reçu ZF analogique (24, 25) et une fréquence ($f_F$) caractéristique d'une bande passante du filtre numérique utilisé (2), et
- le deuxième signal de commande de correction de fréquence (37a, 37b) est utilisé pour un traitement spectral ultérieur du signal reçu numérique (29, 30) avant le filtre numérique (2) et/ou pour un ajustage de la bande passante du filtre numérique (2).

**7.** Circuit selon la revendication 6,
    **caractérisé par le fait que**

- le circuit de traitement de signal comporte en plus un modulateur numérique (5) et un convertisseur DA (7), un signal émis numérique modulé (33, 34) préparé par le modulateur numérique (5) étant converti par le convertisseur DA (7) en un signal émis analogique (26, 27),
- le deuxième signal de commande de correction de fréquence (37b) est envoyé au modulateur numérique (5), et
- le modulateur numérique (5) modifie la fréquence du signal émis numérique modulé produit (33, 34) en fonction du deuxième signal de commande de correction de fréquence (37b).

**8.** Circuit selon l'une des revendications précédentes,
    **caractérisé par le fait que**
    l'estimateur de fréquence (4a) utilise le procédé de calcul instantané pour l'estimation du décalage de fréquence ($\Delta f_X$).

**9.** Circuit selon l'une des revendications 6 à 8,
    **caractérisé par le fait que**

- le circuit de traitement de signal (1) comprend un estimateur de canal (4) estimant la fonction de transmission d'un canal radio, et
- l'estimateur de fréquence (4a) est contenu dans l'estimateur de canal (4).

**10.** Circuit selon l'une des revendications 6 à 9,
    **caractérisé par le fait que**
    l'estimateur de fréquence (4a) effectue pour chaque symbole de données (d) du signal reçu numérique filtré (38, 39) à chaque fois une nouvelle détermination du deuxième signal de commande de correction de fréquence (37a, 37b).

**11.** Circuit selon l'une des revendications 6 à 9,
    **caractérisé par le fait que**

- le signal reçu numérique filtré (38, 39) est divisé en blocs (NB) constitués d'un nombre prédéterminé de symboles de données (d), et
- l'estimateur de fréquence (4a) effectue pour chaque bloc (NB) du signal reçu numérique filtré (38, 39) à chaque fois une nouvelle détermination du deuxième signal de commande de correction de fréquence (37a, 37b).

Fig. 1

Fig. 3

Fig. 4

Fig. 2